# EUROPEAN PATENT APPLICATION

(11) **EP 1 816 904 A1**
(43) Date of publication of application: **08.08.2007**
(21) Application number: 06101346.2
(22) Date of filing: 06.02.2006
(51) Int. Cl.: H05K 3/32

(54) **Memory module with rubber spring connector**

(71) Applicant: Lih Duo International Co., Ltd., Wu Gu Shiang, Taipei Hsien (TW)
(72) Inventor: WANG, Sung-Lai, Wu Gu Shiang, Taipei Hsien (TW)
(74) Representative: Beck, Michael Rudolf

(57) **Abstract**

A memory module (20) comprises a base plate (21) disposed with a plurality of printed circuit sets (22) and one or more IC embedding frames (30) fixed on the base plate (21), particularly each IC embedding frame (30) having a rubber spring connector (40) stored inside which comprises an insulating flexible silicone rubber layer (41) embedded with a conductive spring matrix (45) composed of a group of conductive spring modules in longitudinal and latitudinal matrix arrangement and is through its conductive spring modules formed in electrical connection with a corresponding printed circuit set (22) of the base plate (21); the memory module (20) is to provide IC memory chip being installed in detachable manner taking the advantage of easy installation, convenient maintenance or replacement of IC memory chip without use of SMT, soldering paste or flux.

## Description

### BACKGROUND OF THE INVENTION

### 1. Field of the Invention

The invention relates to a memory module, particularly a memory module having rubber spring connectors allowing IC memory chips to be installed in detachable manner.

### 2. Description of the Prior Art

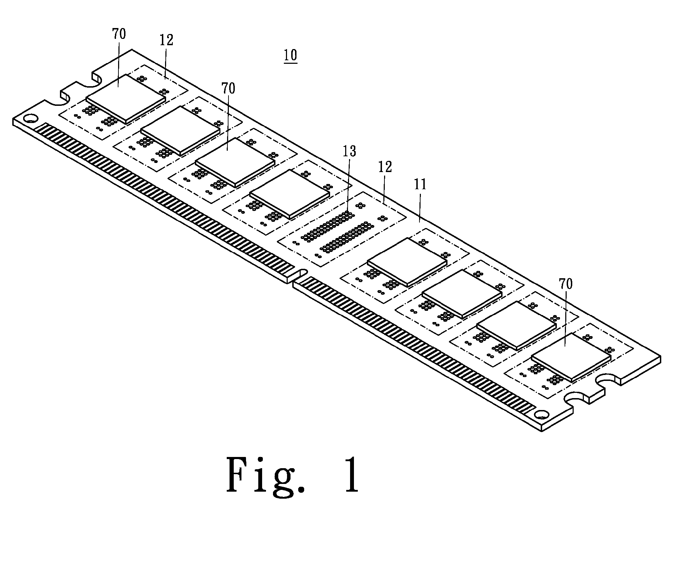

A conventional memory module 10 normally has a structure shown in Fig. 1, which is formed by fixedly installing IC memory chips 70 on one side or both sides of a printed circuit board (PCB) 11 by soldering.

In the prior art memory module 10 as shown in Fig. 1 the PCB 11 has a plurality of printed circuit sets 12 with the same function on the surface. Each printed circuit set 12 has multiple conductive contacts 13 through which IC memory chips 70 can be installed on the PCB 11 by soldering to form an electric connection with the corresponding printed circuit set 12. Therefore, by employing an identical installing process, a plurality of IC memory chips 70 can be arranged and installed on the PCB 11 to form a memory module 10.

In the memory module 10, the IC memory chip 70 soldered thereon is the major element, and the packing method to the IC memory chip 70 has been gradually improved to involve from the Thin Small Outline Package (TSOP) method to the Ball Grid Array (BGA) method.

And, the IC memory chip 70 packaged by Ball Grid Array package is hereinafter referred to as "BGA IC memory chip" which has a plurality of tin balls formed on underside of the IC memory chip 70 and functioned as electric contacts.

As shown in Fig. 1, the BGA IC memory chip 70 can be installed on PCB 11 by employing Surface Mount Technology (SMT) to join the tin balls of BGA IC memory 70 and the corresponding conductive contacts 13 of each printed circuit set 12 on the PCB 11 together by soldering and to securely fix the BGA IC memory chip 70 on the PCB 11.

However, the drawback of fixing the BGA IC memory chip 70 on PCB 11 by means of tin balls and soldering is that it will cause inconvenience in replacement and maintenance of BGA IC memory chip 70. When the BGA IC memory chip 70 is to be removed for repair, in addition to the removal of the original tin balls by de-soldering with high temperature, new tin balls must be re-embedded to BGA IC memory chip 70 and the repaired BGA IC memory chip 70 must be re-positioned and re-soldered to the PCB 11 again. However, there are some difficulties on re-embedding the tin balls and re-positioning the repaired BGA IC memory chip 70.

Especially, during de-soldering and removal of tin balls by high temperature the undamaged BGA IC memory chip 70 soldered on the PCB 11 are likely to be damaged due to high temperature, and, the removed tin balls and the soldering past as well as flux used during re-embedding the new tin balls will cause environmental pollution problem that is detrimental to the environment.

### SUMMARY OF THE INVENTION

In order to overcome the drawbacks of inconvenience in maintenance and replacement of BGA IC memory chips, the invention discloses an innovative memory module which allows installation of BGA IC memory chips on a memory module in detachable manner without the need of soldering past and flux. The innovative memory module disclosed in the invention possesses the advantageous features of easy installation, convenient maintenance and convenient replacement of a BGA IC memory chip and better protection of the environment.

The memory module of the present invention comprises a base plate having a plurality of printed circuit sets with same function, and one or more IC embedding frames securely fixed on the base plate each having a rubber spring connector stored inside particularly being formed in electrical connection with a corresponding printed circuit set on the base plate, so that the memory module of the present invention has functions of providing BGA IC memory chips being installed in detachable manner and providing BGA IC memory chips being easily installed into or removed from the IC embedding frame without need of SMT, solder pastes or fluxes.

The rubber spring connector stored inside the IC embedding frame comprises an insulating flexible silicone rubber layer embedded with a conductive spring matrix composed of a group of conductive spring modules in longitudinal and latitudinal matrix arrangement, therefore, when BGA IC memory chip is freely installed into the IC embedding frame fixed on the base plate of the memory module, a good electrical connection between the BGA IC memory chip and the corresponding printed circuit set on the base plate can be immediately achieved by means of the conductive spring matrix of the rubber spring connector without need of SMT, solder pastes or fluxes.

Accordingly, when it needs to do maintenance or to replace BGA IC memory chip, the work can be carried out simply by removing the damaged BGA IC memory chip and replacing it with a new one without high temperature de-soldering, or when it needs to upgrade the BGA IC memory chip by enlarging the memory capacity, the user can easily replace BGA IC memory chip with the one having large memory capacity. These advantageous features can be concluded as follows:
1. Much easier and simpler to carry out maintenance and replacement of BGA IC memory chip.
2. Reduce the bothering cost and work for re-implanting the tin balls.
3. Replacement and maintenance of BGA IC memory chip can be carried out at any time without the problem of specialized positioning.
4. Avoid BGA IC memory chip getting damaged from high soldering temperature.
5. Replacing BGA IC memory chip or upgrading IC memory chip to enlarge the memory capacity can be easily done by the user itself.
6. Without use of soldering paste and flux to achieve a better effect in environmental protection.

### BRIEF DESCRIPTION OF THE DRAWINGS

Fig. 1 is a schematic diagram of a prior used memory module.
Fig. 2 is a schematic drawing of the memory module of the present invention showing on the memory module has installed a plurality of rubber spring connectors through which BGA IC memory chips are capably installed on memory module in detachable manner.
Fig. 3 is an enlarged schematic drawing of the rubber spring connector in Fig. 2 showing the rubber spring connector is provided with conductive spring matrix.
Fig. 4 is an enlarged sectional view along line 4-4 of Fig. 2 showing by use of the rubber spring connector a good electrical connection constructed between BGA IC memory chip and corresponding printed circuit set disposed on the memory module without need of SMT, solder pastes or fluxes.
Fig. 5 is an illustrating drawing to illustrate the memory module of the present invention has another practical application applied to provide a kind of plane IC memory chip with flat surface on underside capably installed on memory module in detachable manner.

### DESCRIPTION OF THE PREFERRED EMBODIMENT

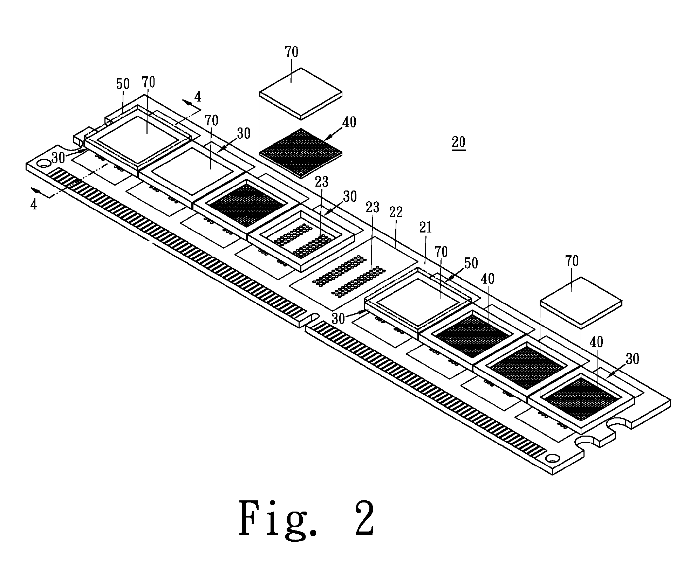

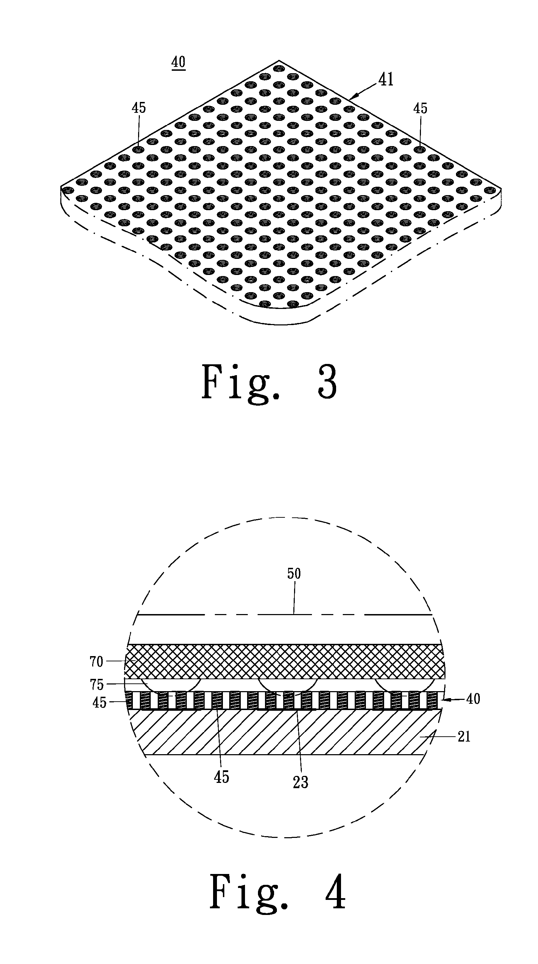

As shown in Figs. 2 and 4, the memory module 20 of the present invention is structured to allow the BGA IC memory chip 70 having tin balls 75 on underside to be installed on the memory module 20 of the present invention in detachable manner.

The structure of memory module 20 of the present invention has a base plate 21 and one or more IC embedding frames 30 securely fixed on one side or both sides of the base plate 21, in particular, each IC embedding frame 30 is coupled with a movable cover 50 and has stored a rubber spring connector 40 functioned as an electrical connector inside to enable the effect of easy installation and easy removal of a BGA IC memory chip 70 into and from the memory module 20 without need of SMT, solder pastes or fluxes.

As shown in Figs. 2 and 4, the base plate 21 is a printed circuit board adapted for installing the memory module 20 of the present invention. The base plate 21 is provided with a plurality of printed circuit sets 22 with identical functions on one side or both sides of the base plate 21. Each printed circuit set 22 of the base plate 21 is relative to a corresponding IC embedding frame 30 after the corresponding IC embedding frame 30 has been securely fixed on the base plate 21, and each printed circuit set 22 of the base plate 21 has a plurality of contacts 23 for electrical connection with the rubber spring connector 40 stored inside the corresponding IC embedding frame 30.

As shown in Figs. 2 and 3, each rubber spring connector 40 mentioned above has an insulating flexible silicone rubber layer 41 already embedded with a conductive spring matrix 45 composed of a group of conductive spring modules arranged in longitudinal and latitudinal matrix arrangement.

And, the rubber spring connector 40 is constructed from an elastomer having the characteristics of elasticity and electric conductivity and serves as a functional connector which enables an isolated or obstructed circuit to be connected as an entire current circuit to have current flow into the circuit via the conductive spring matrix 45 of the rubber spring connector 40.

Due to the rubber spring connector 40 being an elastomer, when the insulating flexible silicone rubber layer 41 of the rubber spring connector 40 is impacted by an external force or collision, each conductive spring module arranged in the conductive spring matrix 45 of the rubber spring connector 40 provides a buffer effect to absorb the outside force or collision by compressed distortion and to resume their original position by elastic extension once the external impact or collision has disappeared.

Therefore, after a rubber spring connector 40 is stored into one of the IC embedding frames 30 of the base plate 21, an electrical connection will be achieved between the rubber spring connector 40 and a corresponding printed circuit set 22 of the base plate 21 through the contacts 23 of the corresponding printed circuit set 22 being electrically connected with the conductive spring matrix 45 of the stored rubber spring connector 40.

As shown in Figs. 2 and 4, when the movable cover 50 coupled with a corresponding IC embedding frame 30 of the memory module 20 is moved to have the corresponding IC embedding frame 30 become in opened status, a BGA IC memory chip 70 shall be freely embedded into the corresponding IC embedding frame 30 of the memory module 20 in detachable manner, or an embedded BGA IC memory chip 70 shall be dismounted from the corresponding IC embedding frame 30 of the memory module 20 freely.

And, when the movable cover 50 is subsequently moved to have the corresponding IC embedding frame 30 returned to become in closed status again, the BGA IC memory chip 70 already embedded into the corresponding IC embedding frame 30 of the memory module 20 shall be prevented from movement. At the moment, as shown in Fig. 4, the tin balls 75 formed on underside of the embedded BGA IC memory chip 70 will touch and press the conductive spring matrix 45 of the rubber spring connector 40 having stored inside the corresponding IC embedding frame 30 to enable a tight contact between the tin balls 75 of the embedded BGA IC memory chip 70 and the conductive spring matrix 45 of the rubber spring connector 40 to form a good electric connection, and thus an electrical connection is further formed between the embedded BGA IC memory chip 70 and one of the printed circuit set 22 of the base plate 21.

Hence, no SMT, solder paste or flux is required for installing the BGA IC memory chip 70 on the memory module 20 of the present invention so that replacement and maintenance of any BGA IC memory chips 70 installed on the memory module 20 shall be carried out at any time without the problem of specialized positioning. In other wards, the memory module 20 of the present invention provides that it is much easier and simpler to carry out maintenance and replacement of BGA IC memory chip 70, and installing the BGA IC memory chip 70 is so environmentally friendly to achieve a better effect in environmental protection.

When a defective BGA IC memory chip 70 needs to be repaired or replaced is found on the memory module 20 of the present invention, the repair or replacement work can be simply done by removing the defective BGA IC memory chip 70 from its corresponding IC embedding frame 30 of the memory module 20, and then installing a new BGA IC memory chip 70 into the corresponding IC embedding frame 30, i.e., the repair or replacement work is so convenient and simple that it does not need to process de-soldering with high temperature and shall prevent other good BGA IC memory chip 70 from damage due to high temperature.

When upgrading the memory module 20 and enlarging memory capacity of the BGA IC memory chip 70 is required, users only needed to do is simply to remove the embedded BGA IC memory chips 70 out of its corresponding IC embedding frames 30 of the memory module 20 and then reinstall new BGA IC memory chips 70 with larger memory capacity into the corresponding IC embedding frames 30 without any problem.

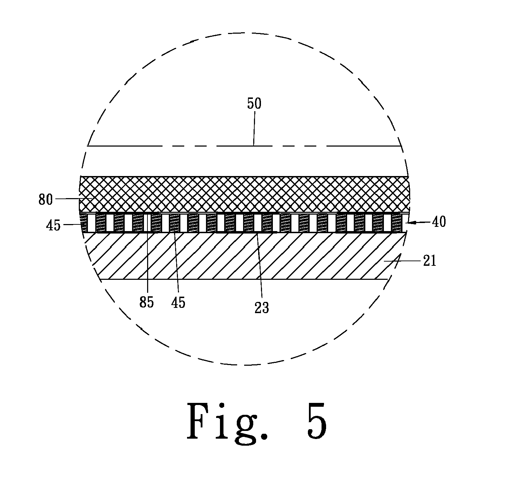

In addition, the memory module 20 of the present invention is also to allow another kind of IC memory chip to be installed on the memory module 20 in detachable manner. As shown in Fig. 5, a kind of IC memory chip 80 with non-BGA package having conductive contacts 85 on its flat underside shall be easily and freely embedded into or removed from the IC embedding frame 30 of the memory module 20. It does not require using SMT, soldering paste or flux for IC maintenance and replacement as same as that of the BGA IC memory chip 70 mentioned above.

## Claims

1. Memory module for detachable installation of an IC memory chip, the memory modul comprising:
- a base plate (21) having a plurality of printed circuit sets (22) formed thereon,
- one or more IC embedding frames (30) fixed on one side or both sides of the base plate (21), and
- a rubber spring connector (40) stored inside each IC embedding frame (30), respectively;
wherein the rubber spring connector (40) comprises an insulating flexible silicone rubber layer (41) embedded with a conductive spring matrix (45) composed of a group of conductive spring modules in longitudinal and latitudinal matrix arrangement, and
wherein the rubber spring connector (40) stored inside its corresponding IC embedding frame (30) is through its conductive spring modules formed in electrical connection with a corresponding printed circuit set (22) of the base plate (21).

2. Memory module according to claim 1, wherein each IC embedding frame (30) fixed on the base plate (21) is coupled with a movable cover (50), and wherein the corresponding IC embedding frame (30) is adapted to be opened or closed by moving the movable cover (50).

3. Memory module according to claim 1 or 2, wherein each IC embedding frame (30) has further embedded into a BGA IC memory chip (70) having tin balls (75) on its underside or an IC memory chip (80) with non-BGA package having conductive contacts (85) on its flat underside, and the embedded IC memory chip (70 or 80) is through its tin balls (75) or conductive contacts (85) formed in electrical connection with the conductive spring matrix (45) of the rubber spring connector (40) stored inside the corresponding IC embedding frame (30).
